# EUROPEAN PATENT APPLICATION

(11) **EP 2 621 088 A1**
(43) Date of publication of application: **31.07.2013**
(21) Application number: 12193060.6
(22) Date of filing: 16.11.2012
(51) Int. Cl.: H03H 9/05, H03H 9/10

(54) **Vibration device and oscillator**

(30) Priority: 27.01.2012 JP 2012014965
(71) Applicant: Seiko Instruments Inc., Chiba-shi, Chiba (JP)
(72) Inventor: Yoshida, Yoshifumi, Chiba-shi, Chiba (JP)
(74) Representative: Miller Sturt Kenyon

(57) **Abstract**

A vibration device according to an embodiment of the present invention includes a base, a lid body bonded to the base to form a cavity and a vibrating reed housed in the cavity. The vibrating reed includes a main body and an extended portion extending in a short side direction of the main body, and in the vibrating reed, the extended portion is supported by a first connection portion arranged on the base and the main body is supported by a second connection portion in a cantilever manner. Accordingly, when ambient temperature changes and a stress is applied between the first and second connection portions, the stress is alleviated by the extended portion.

## Description

### BACKGROUND OF THE INVENTION

### FIELD OF THE INVENTION

The present invention relates to a vibration device and an oscillator in which a vibrating reed is mounted on a cavity formed between two substrates.

### BACKGROUND ART

A vibration device using a crystal unit is in common use. The vibration device using the crystal unit is small in size and has stable frequency characteristics with respect to temperature change, and is widely used as a timing source for portable information terminals such as a cellular phone and many other electronic devices. Further reduction in size and stabilization in an oscillation period are requested in recent years. Accordingly, the crystal unit is further reduced in size and mounted on a substrate by using a surface mount method.

Figs. 5A and 5B are explanatory views of a crystal unit described in JP-A-2008-109538 (Patent Document 1) (Fig. 1 in Patent Document 1). Fig. 5A is a cross-sectional view of the crystal unit and Fig. 5B is a plan view of the crystal unit in which a metal cover 53 is removed. The crystal unit includes a container main body 51 in which a recessed portion is formed, a crystal piece 52 mounted on the bottom of the recessed portion and a metal cover 53 installed on an upper end of the recessed portion to seal the recessed portion. The crystal piece 52 is supported in the container main body 51 by a conductive adhesive 58 in a cantilever manner.

The crystal piece 52 has a flat rectangular shape, including an excitation electrode 56 for exciting the crystal piece 52, a first lead-out portion 57a electrically connected to the excitation electrode 56 and a second lead-out portion 57b electrically connected to the first lead-out portion 57a and installed at a corner portion of the crystal piece 52 on a surface of the crystal piece 52. An excitation electrode 56 is formed on both surfaces of the crystal piece 52 so as to sandwich the crystal piece 52. A second lead-out portion 57b is formed at both corner portions of a short side of the crystal piece 52, in which the second lead-out portion 57b at one corner is electrically connected to the excitation electrode 56 formed on one surface and the second lead-out portion 57b at the other corner portion is electrically connected to the excitation electrode 56 formed on the other surface. The second lead-out portion 57b is electrically connected to a crystal terminal 54 through the conductive adhesive 58, and further connected to an external terminal 55. Therefore, the crystal piece 52 is supported in a cantilever manner so that the both corner portions of the short side are fixed to the container main body 51 by the conductive adhesive 58.

### SUMMARY OF THE INVENTION

In the mount method of Patent Document 1, two points in the short side of the crystal piece 52 are fixed to the container main body 51 by the conductive adhesive 58. When the thermal expansion coefficient differs between the crystal piece 52 and the container main body 51, a stress is applied between two fixing portions when the ambient temperature changes. Accordingly, frequency characteristics are deteriorated with respect to the temperature change. Particularly, in the case where the crystal piece 52 is an AT cut crystal piece which performs thickness shear vibration, deterioration in frequency characteristics becomes conspicuous with respect to the ambient temperature change when the two points in the short side of the crystal piece 52 are fixed by the conductive adhesive 58.

Incidentally, this kind of vibration device keeps the inside of the container in a vacuum state for reducing air resistance. However, gas is generated from the conductive adhesive 58 when using the conductive adhesive 58 as in Patent Document 1, and frequency characteristics of the crystal piece 52 vary due to the generated gas. The crystal piece 52 is mounted on the container main body 51 by thermally melting the conductive adhesive 58. The conductive adhesive 58 spreads when being melted and it is difficult to control a joint area between the crystal piece 52 and the container main body 51 to be small. Furthermore, vibration characteristics of the crystal piece 52 are deteriorated when the joint area spreads. Accordingly, the reduction in size of the crystal piece 52 is limited. Additionally, as it takes time to solidify the conductive adhesive 58, the crystal piece 52 may tilt under its weight and touch a package while the crystal piece 52 is adhered to the container body 51, which interferes with vibration. According to the above reasons, it is difficult to apply the method of mounting the crystal piece 52 on the container main body 51 by using the conductive adhesive 58 for obtaining high-precision frequency characteristics.

The present invention has been made in view of the above problems, and an object thereof is to provide a small and high-precision vibration device which can suppress the deterioration in frequency characteristics with respect to change of ambient temperature.

A vibration device according to an embodiment of the present invention includes a base, a lid body bonded to the base to form a cavity and a vibrating reed housed in the cavity, in which the vibrating reed includes a flat main body having a rectangular shape, and an extended portion extending in a short side direction of the rectangular shape at one corner portion of the main body, the main body has two excitation electrodes for exciting vibration, the extended portion has a first terminal electrically connected to one excitation electrode, the main body has a second terminal electrically connected to the other excitation electrode and arranged in the vicinity of a short side where the extended portion is installed, and the base has a first connection portion connected to the first terminal on a surface facing the cavity and a second connection portion connected to the second terminal, thereby supporting the vibrating reed by the first and second connection portions in a cantilever manner.

Preferably, the second connection portion is connected to an approximate center of a width in the short side direction of the main body.

Preferably, the extended portion is formed in a shape of an L-shaped arm in plan view of a surface of the flat main body seen from a vertical direction, in which one end of the L-shaped arm is connected to the main body and the first connection portion is connected in the vicinity of the other end of the L-shaped arm.

Preferably, one side of the L-shaped arm is extended in the short side direction of the main body and the other side of the L-shaped arm is in parallel to a longitudinal direction of the main body toward a direction of an opposite side of the short side where the extended portion is installed.

Alternatively, it is preferred that the extended portion has a concave shape or a spiral shape in plan view of a surface of the flat main body seen from a vertical direction, one end of the concave shape or the spiral shape is connected to the main body and the first connection portion is connected in the vicinity of the other end thereof.

Preferably, the vibrating reed is an AT cut crystal vibrating reed.

Preferably, he first and second connection portions are formed by using metal bumps.

Preferably, he metal bumps are gold bumps.

Preferably, he base includes a first wiring electrically connected to the first connection portion, a second wiring electrically connected to the second connection portion and first and second through electrodes piercing through the base as well as electrically connected to the first and second wirings respectively.

An oscillator according to an embodiment of the present invention includes the vibration device described in any of the above and a drive circuit supplying drive signals to the vibration device.

The vibration device according to the embodiment of the present invention includes the base, the lid body bonded to the base to form the cavity and the vibrating reed housed in the cavity, in which the vibrating reed includes the flat main body having the rectangular shape, and an extended portion extending in the short side direction of the rectangular shape at one corner portion of the main body, the main body has two excitation electrodes for exciting vibration, the extended portion has the first terminal electrically connected to one excitation electrode, the main body has the second terminal electrically connected to the other excitation electrode and arranged in the vicinity of a short side where the extended portion is installed, and the base has the first connection portion connected to the first terminal on the surface facing the cavity and the second connection portion connected to the second terminal, thereby supporting the vibrating reed by the first and second connection portions in a cantilever manner. Accordingly, the vibration device in which deterioration in frequency characteristics is reduced if ambient temperature changes.

### BRIEF DESCRIPTION OF THE DRAWINGS

Embodiments of the present invention will now be described by way of further example only and with reference to the accompanying drawings, in which:
Figs. 1A to 1C are explanatory views of a vibration device according to a first embodiment of the present invention;
Figs. 2A to 2C show modification examples of a vibrating reed used for the vibration device the embodiment of the present invention;
Fig. 3 is a schematic plan view of the base in the state in which a lid body of the vibration device is removed according to a second embodiment of the present invention;
Fig. 4 is a schematic view of an upper surface of an oscillator according to a third embodiment of the present invention; and

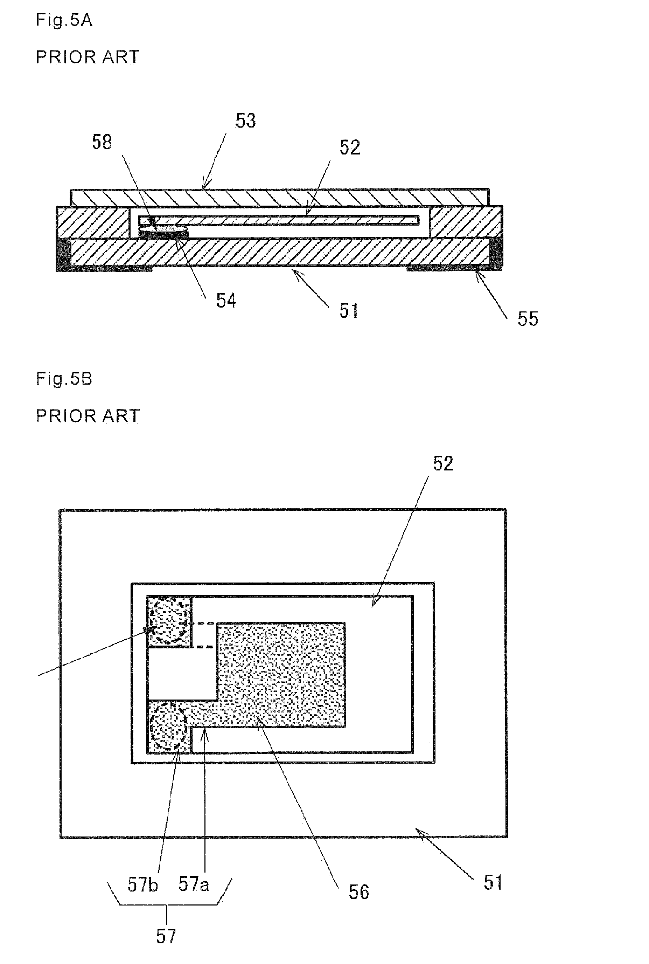

Figs. 5A and 5B are explanatory views of a related-art crystal unit.

### DESCRIPTION OF THE PREFERRED EMBODIMENTS

### (First Embodiment)

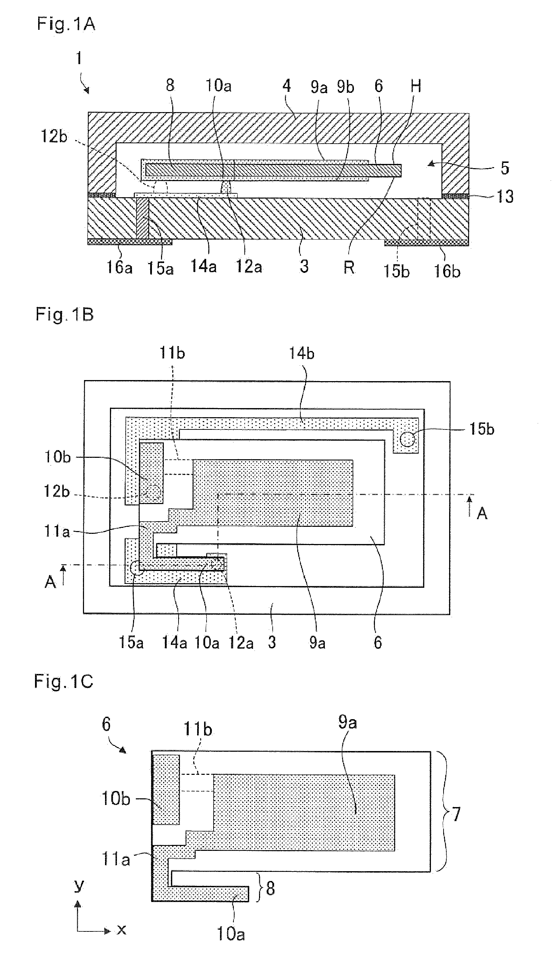

Figs. 1A to 1C are explanatory views of a vibration device 1 according to a first embodiment of the present invention. Fig. 1A is a schematic view in longitudinal cross section of a vibration device 1, Fig. 1B is a schematic plan view of a base 3 in a state in which a lid body 4 is removed and Fig. 1C is a schematic view of an upper surface of a vibrating reed 6. Fig. 1A shows a cross section of a portion AA of Fig. 1B.

As shown in Figs. 1A to 1C, the vibration device 1 includes the base 3, the lid body 4 bonded to the base 3 and forming a cavity 5 and the vibrating reed 6 housed in the cavity 5. The vibrating reed 6 includes a flat main body 7 having a rectangular shape and an extended portion 8 extending in a short side direction (-y direction) of the rectangular shape at a corner portion where a lower side and a left side intersect at one corner portion (Fig. 1C) of the main body 7. In this specification, the expression "at a corner portion" and like expressions include "in the vicinity of a corner portion" and like expressions. The main body 7 includes two excitation electrodes 9a and 9b for exciting vibration. The extended portion 8 has a first terminal 10a electrically connected to one excitation electrode 9a, and the main body 7 has a second terminal 10b electrically connected to the other excitation electrode 9b and arranged in the vicinity of the short side at which the extended portion 8 is installed. The base 3 includes a first connection portion 12a connected to the first terminal 10a on the surface facing the cavity 5 and a second connection portion 12b connected to the second terminal 10b, the vibrating reed 6 being supported in a cantilever manner by the first and second connection portions 12a and 12b.

As described above, as the vibrating reed 6 is supported by two points, one in the main body 7 and the other in the extended portion 8, the vibrating reed 6 can be supported more elastically than in the case of supporting the vibrating reed 6 by two points in the main body 7. That is, when ambient temperature changes and a stress is applied between a point in the main body 7 and another in the extended portion 8 due to a difference in the thermal expansion coefficient in the case where the thermal expansion coefficient differs between the base 3 and the vibrating reed 6, the stress is alleviated by the extended portion 8 to thereby reduce effects on vibration characteristics.

Hereinafter, explanation will be specifically made. As shown in Fig. 1A and 1C, the vibrating reed 6 includes the flat main body 7 having the rectangular shape and the extended portion 8 extending in the short side direction (-y direction) of the rectangular shape at the corner portion where the lower side and the left side of the main body 7 intersect. The main body 7 includes excitation electrodes 9a and 9b so as to sandwich the vibrating reed 6 by a front surface H and a rear surface R on the opposite side.

The extended portion 8 has a shape of an L-shaped arm in plan view of the front surface H of the flat main body 7 seen from a vertical direction, in which one end thereof is connected to the main body 7 and the other end is supported by the first connection portion 12a. The extended portion 8 includes the first terminal 10a on the front surface H and the rear surface R, in which the first terminal 10a is electrically connected to the excitation electrode 9a on the front surface H through a wiring 11a as well as electrically connected to the first connection portion 12a. Accordingly, the first connection portion 12a is electrically connected to the excitation electrode 9a installed on the front surface H of the main body 7.

The main body 7 includes the second terminal 10b on the front surface H and the rear surface R from the center of the left side where the extended portion 8 is installed toward an upper side (as viewed in figs. 1B and 1C), and the second terminal 10b is electrically connected to the excitation electrode 9b on the rear surface R through a wiring 11b. The main body 7 is supported by the second connection portion 12b connected to an approximate center of a width in the short side direction (y direction) of the main body 7 and the second connection portion 12b is electrically connected to the second terminal 10b. Therefore, the second connection portion 12b is electrically connected to the excitation electrode 9b installed on the rear surface R of the main body 7.

The extended portion 8 is connected so that one shorter side of the L-shaped arm extends in the short side direction (-y direction) from the main body 7 and so that the other longer side of the L-shaped arm extends along a longitudinal direction (x direction) of the main body 7. In the vibrating reed 6, an end portion of the L-shaped arm on the opposite side of the connection portion with respect to the main body 7 is supported by the first connection portion 12a, and a portion in the vicinity of the left side of the main body 7, in addition to the approximate center of the width in the short side direction of the main body 7, is supported by the second connection portion 12b. If the ambient temperature changes and a portion between the vibrating reed 6 and the base 3 expands and contracts due the difference in thermal expansion coefficient, the expansion and contraction are absorbed by the L-shaped arm of the extended portion 8. Therefore, the stress applied on the main body 7 is alleviated and the deterioration in frequency characteristics due to temperature change can be reduced. Additionally, the second connection portion 12b supports the approximate center of the width in the short side direction of the main body 7, therefore, effects on the vibration of the main body 7 are reduced.

The base 3 includes a first wiring 14a electrically connected to the first connection portion 12a, a second wiring 14b electrically connected to the second connection portion 12b and first and second through electrodes 15a, 15b piercing through the base 3 and electrically connected to the first and second wirings 14a and 14b respectively. On a surface of the base 3 on the opposite side to the cavity 5, an external terminal 16a electrically connected to the first through electrode 15a and an external terminal 16b electrically connected to the second through electrode 15b are provided. Drive signals are inputted to the external terminals 16a and 16b from a control circuit and the like. In Fig. 1B, the first and second through electrodes 15a and 15b are arranged at opposing corners of a rectangle of the cavity 5, namely, the first through electrode 15a is arranged in the vicinity of a corner portion made by a left side and a lower side of the cavity 5, which is a rectangular shape in plan view, and the second through electrode 15b is arranged in the vicinity of a corner portion made by an upper side and a right side. The first wiring 14a is arranged on the lower side near the left side and electrically connects the first connection portion 12a to the first through electrode 15a. The second wiring 14b is arranged from the center of the left side toward a corner portion made by the left side and the upper side and further toward a corner portion made by the upper side and the right side along the upper side, which electrically connects the second connection portion 12b to the second through electrode 15b.

Here, an AT cut crystal piece can be used as the vibrating reed 6. The vibration device can be miniaturized by using the AT cut crystal piece. The AT cut crystal piece can be cut out individually from an AT cut crystal plate by photolithography and an etching method. Therefore, the extended portion 8 extending from one corner of the main body 7 can be easily formed by photolithography and the etching method at the time of cutout. As the base 3 and the lid body 4, ceramic materials such as alumina ceramics can be used. Glass materials can be also used instead of ceramic materials. When using glass materials, the thermal expansion coefficient can be approximately the same as the coefficient of the vibrating reed 6, which can further reduce the deterioration in frequency characteristics due to temperature change.

As the first and second connection portions 12a and 12b, metal bumps such as gold bumps can be used. Additionally, an electrode having a stacked structure of gold (Au) and Cr is formed on the main body 7 and the extended portion 8, and the electrode is patterned to thereby form the excitation electrodes 9a, 9b, the wirings 11a, 11b, the first and second terminals 10a, 10b. Then, the vibrating reed 6 is mounted on the first and second connection portions 12a and 12b of the base 3 by flip-chip bonding. When using the metal bumps as the first and second connection portions 12a and 12b, an area of a holding portion holding the vibrating reed 6 can be smaller than in the case of using adhesive.

When using metal bumps as the first and second connection portions 12a and 12b, gas is not generated such as in the case of the conductive adhesive, therefore, frequency characteristics do not change due to the generated gas. When the vibrating reed 6 is mounted by using the metal bumps, the first and second connection portions 12a and 12b are solidified in a shorter time than in the case of using the conductive adhesive, therefore, it is possible to prevent the vibrating reed 6 from tilting under its own weight and touching the base 3 to interfere with vibration. The lid body 4 can be bonded to the base 3 by an anodic bonding through a bonding material 13 made of, for example, an aluminum film. The anodic bonding can be performed in a vacuum, and the vacuum can be maintained inside the cavity 5 after the bonding.

In the present embodiment, the vibrating reed 6 is mounted on the base 3 by flip-chip bonding, therefore, an outline of the vibration device 1 can be formed to be small. The base 3 can be formed so that a width in the short side direction (y direction) is 2.5mm to 1.2mm, a width in the longitudinal direction(x direction) is 3.2mm to 1.6mm.

### (Modification Examples)

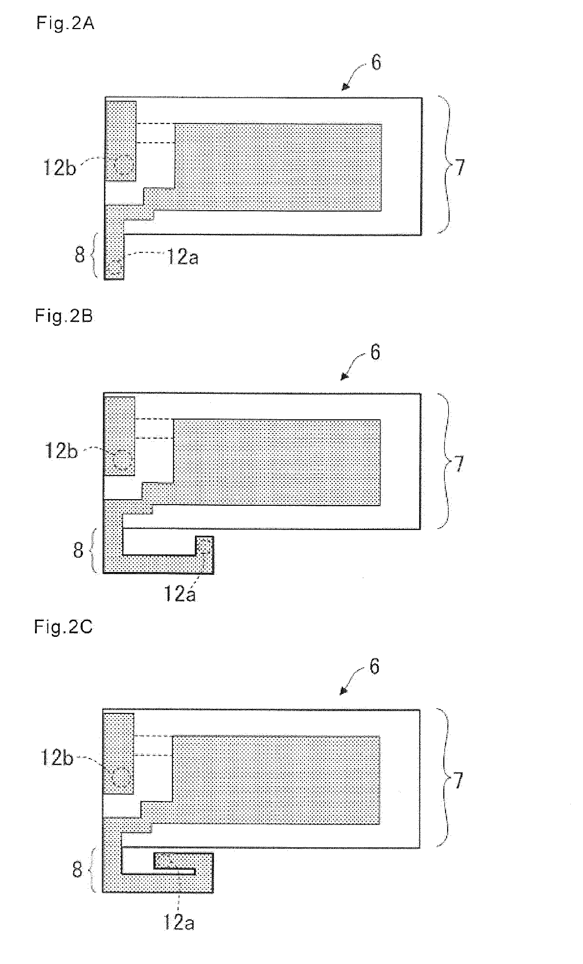

Figs. 2A to 2C show modification examples of the vibrating reed 6 used for the vibration device 1 according to the embodiment of the present invention. The vibrating reed 6 includes the flat main body 7 having a rectangular shape and the extended portion 8 extending in the short side direction of the rectangular shape from one corner portion (including the vicinity of one corner portion) of the main body 7. In Fig. 2A, the extended portion 8 has a bar shape and is connected to the main body 7 so that the short side of the main body 7 is extended. In Fig. 2B, the extended portion 8 has a concave shape and one upper end portion of the concave portion is connected to one corner portion of the main body 7. In Fig. 2C, the extended portion 8 has a spiral shape, and an outer end portion of the spiral shape is connected to one corner portion of the main body 7. The first connection portion 12a supports an end portion on the opposite side of the end of the extended portion 8 connected to the main body 7. The second connection portion 12b is connected in the vicinity of the short side where the extended portion 8 is arranged as well as in the approximate center of the width in the short side direction of the main body 7.

In any case of Fig. 2A to 2C, the vibrating reed 6 can be supported at two points of the main body 7 and the extended portion 8 more elastically than in the case of supporting the vibrating reed 6 at two points of the main body 7. Particularly, in Fig. 2B and 2C, the main body 7 is supported so as to buffer both a stress with respect to the short side direction of the main body 7 and a stress with respect to the longitudinal direction of the main body 7. Accordingly, the stress due to the difference in the thermal expansion coefficient between the base 3 and the vibrating reed 6 with respect to the change of ambient temperature is alleviated, which reduces effects on vibration characteristics.

The second connection portion 12b may support an upper position of the width than the approximate center or may support a lower position of the width than the approximate the center instead of supporting the approximate center of the width in the short side direction of the main body 7. However, vibration is stabilized more effectively when supporting the approximate center of the width in the short side direction of the main body 7 as compared with the case of supporting the lower position or the upper position of the width.

### (Second Embodiment)

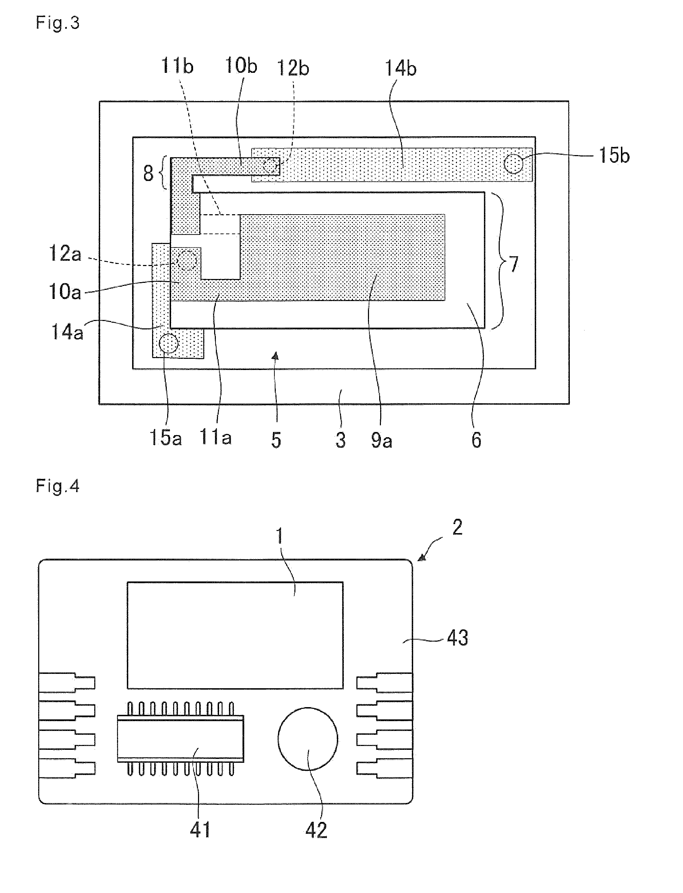

Fig. 3 is a schematic plan view of the base 3 in the state in which the lid body 4 of the vibration device 1 is removed according to a second embodiment of the present invention. The second embodiment differs from the first embodiment in a point that the extended portion 8 is connected to a position near an upper side of the vibrating reed 6 and a point that the shape and connection of the first and second wirings 14a and 14b installed in the base 3 and the first and second terminal 10a and 10b installed in the vibrating reed 6 are changed. The second embodiment is the same as the first embodiment except the above points. Accordingly, the different points will be chiefly explained and explanation about the equivalent points is omitted.

As shown in Fig. 3, in the extended portion 8 having the shape of the L-shaped arm, one end is connected to a corner portion made by a left side and an upper side of the main body 7 and the other end is supported by the second connection portion 12b. The extended portion 8 has the second terminal 10b on the front surface and the rear surface thereof, which is electrically connected to the not-shown excitation electrode 9b through the wiring 11b formed on the rear surface of the main body 7. The main body 7 includes the first terminal 10a on the front surface and the rear surface from the approximate center of the left side toward a lower side, which is electrically connected to the excitation electrode 9a through the wiring 11a formed on the surface of the main body 7. The first and second through electrodes 15a, 15b are arranged in the vicinity of a corner portion of the cavity 5 made by a lower side and a left side and in the vicinity of a corner portion made by an upper side and a right side. The first wiring 14a is arranged from the approximate center of the left side to the vicinity of a lower side along the left side, which electrically connects the first connection portion 12a to the first through electrode 15a. The second wiring 14b is arranged from a position near the left side to the vicinity of the right side along the upper side, which electrically connects the second connection portion 12b to the second through electrode 15b. Accordingly, the total wiring length of the first and second wirings 14a and 14b can be formed shorter than the case of the first embodiment.

The present invention is not limited to the layout of the second embodiment, and for example, the first and second through electrodes 15a and 15b may be arranged in the vicinity of a corner portion made by the left side and the upper side of the cavity 5 and in the vicinity of a corner portion made by the right side and the lower side. In this case, a layout obtained by vertically inverting the vibrating reed 6, the second connection portion 12b and the first and second wirings 14a, 14b shown in Fig. 3 can be applied.

### (Third Embodiment)

Fig. 4 is a schematic view of an upper surface of an oscillator 2 according to a third embodiment of the present invention. In the third embodiment, the oscillator 2 is formed by integrating the vibration device 1 according to the first embodiment or the second embodiment. As shown in Fig. 4, the oscillator 2 includes a substrate 43, the vibration device 1 installed on the substrate, an integrated circuit 41 and an electronic component 42. The vibration device 1 generates a signal with a fixed frequency based on the drive signals given to the external terminals 16a and 16b, and the integrated circuit 41 and the electronic component 42 processes the signal with the fixed frequency supplied from the vibration device 1 to generate a reference signal such as a clock signal. The vibration device 1 according to the embodiment of the present invention can be formed smaller with high reliability, therefore, it is possible to form the entire oscillator 2 to be further compact in size.The foregoing description has been given by way of example only and it will be appreciated by a person skilled in the art that modifications can be made without departing from the scope of the present invention.

## Claims

1. A vibration device (1) comprising:
a base (3);
a lid body (4) bonded to the base to form a cavity (5); and
a vibrating reed (6) housed in the cavity,
wherein the vibrating reed includes a flat main body (7) having a rectangular shape, and an extended portion (8) extending in a short side direction of the rectangular shape at one corner portion of the main body,
the main body has two excitation electrodes (9a, 9b) for exciting vibration,
the extended portion (8) has a first terminal (10a) electrically connected to one excitation electrode (9a),
the main body has a second terminal (10b) electrically connected to the other excitation electrode (9b) and arranged in the vicinity of a short side where the extended portion is installed, and
the base has a first connection portion (12a) connected to the first terminal (10a) on a surface (R) facing the cavity and a second connection portion (12b) connected to the second terminal (10b), thereby supporting the vibrating reed by the first and second connection portions in a cantilever manner.

2. The vibration device according to claim 1,
wherein the second connection portion (12b) is connected to an approximate center of a width in the short side direction of the main body.

3. The vibration device according to claim 1 or claim 2,
wherein the extended portion (8) is formed in a shape of an L-shaped arm in plan view of a surface of the flat main body (7) seen from a vertical direction, in which one end of the L-shaped arm is connected to the main body and the first connection portion (12a) is connected in the vicinity of the other end of the L-shaped arm.

4. The vibration device according to claim 3,
wherein one side of the L-shaped arm is extended in the short side direction of the main body and the other side of the L-shaped arm is extended in parallel to a longitudinal direction of the main body toward a direction of an opposite side of the short side where the extended portion is installed.

5. The vibration device according to claim 1 or claim 2,
wherein the extended portion (8) has a concave shape or a spiral shape in plan view of a surface of the flat main body seen from a vertical direction, one end of the concave shape or the spiral shape is connected to the main body (7) and the first connection portion (12a) is connected in the vicinity of the other end thereof.

6. The vibration device according any one of the preceding claims,
wherein the vibrating reed is an AT cut crystal vibrating reed.

7. The vibration device according to any one of the preceding claims,
wherein the first and second connection portions (12a, 12b) are formed by using metal bumps.

8. The vibration device according to claim 7,
wherein the metal bumps are gold bumps.

9. The vibration device according to any one of the preceding claims,
wherein the base (3) includes a first wiring (14a) electrically connected to the first connection portion (12a), a second wiring (14b) electrically connected to the second connection portion (12b), and first and second through electrodes (15a, 15b) piercing through the base as well as electrically connected to the first and second wirings respectively.

10. An oscillator comprising:
the vibration device according to any one of the preceding claims; and
a drive circuit supplying drive signals to the vibration device.
